Europäisches Patentamt

European Patent Office

Office européen des brevets

(19)

(11) Publication number: **0 041 639**
**B1**

# EUROPEAN PATENT SPECIFICATION

(12)

(45) Date of publication of patent specification: **05.03.86**

(51) Int. Cl.⁴: **G 03 F 7/16**

(21) Application number: **81103995.7**

(22) Date of filing: **25.05.81**

(54) Laminating process.

(30) Priority: **27.05.80 US 153638**

(43) Date of publication of application:
**16.12.81 Bulletin 81/50**

(45) Publication of the grant of the patent:
**05.03.86 Bulletin 86/10**

(84) Designated Contracting States:
**AT BE CH DE FR GB IT LI LU NL SE**

(56) References cited:
**FR-A-2 047 506**
**GB-A- 898 871**
**US-A-3 629 036**

(73) Proprietor: **E.I. DU PONT DE NEMOURS AND COMPANY**
**1007 Market Street**
**Wilmington Delaware 19898 (US)**

(72) Inventor: **Cohen, Abraham Bernard**
**33 Hemlock Terrace**
**Springfield New Jersey 07081 (US)**

(74) Representative: **Werner, Hans-Karsten, Dr. et al**
**Deichmannhaus am Hauptbahnhof**
**D-5000 Köln 1 (DE)**

Courier Press, Leamington Spa, England.

**Description**

The invention relates to a process for laminating an absorptive photosensitive layer underlying a flexible support to a substrate surface by means of pressure, comprising the step of applying a thin layer of liquid on the substrate surface immediately prior to lamination, which layer forms an interface between the substrate surface and the photosensitive layer upon lamination.

In the manufacture of printed circuit boards from conventional photoresist elements, it is necessary to laminate the photosensitive layer of the element to the substrate board in such manner that the layer is firmly adhered thereto without occlusions and other phase discontinuities such as entrapped air. Furthermore, in many manufacturing situations, it is also desirable that a strong adhesive bond be formed instantly so that subsequent operations can proceed.

U.S. Patent 3,547,730 discloses the lamination of photoresist layer to a substrate by passing the layer and substrate through the nip of heated spring-loaded laminating rolls. The photoresist layer and/or the substrate may be preheated prior to the lamination step. The purpose of this heating is to enable the layer to be forced into intimate contact with the substrate under the pressure of the rolls, whereby the layer achieves sufficient adhesion to the substrate to withstand subsequent photoresist processing steps such as solvent development and etching or plating of the substrate.

U.S. Patent 3,629,036 discloses the use of a solution of photoresist to coat the substrate prior to lamination with a layer of photoresist. The coating solution purportedly enables sufficient adhesion to be obtained without heating being required for lamination. The coating solution is applied by pressing wicks against the substrate.

Though the prior art methods of lamination are satisfactory for many applications, there is a need for even more precise and uniform lamination methods, especially where printed circuit boards having a very high line density are being fabricated. The invention is therefore directed to a process for laminating an absorptive photosensitive layer underlying a flexible support to a substrate surface by means of pressure, comprising the step of applying a thin layer of liquid on the substrate surface immediately prior to lamination, which layer forms an interface between the substrate surface and the photosensitive layer upon lamination and is displaced by absorption into the photosensitive layer during .lamination, characterized in that the liquid is a nonsolvent with respect to the photosensitive layer; and is a member selected from the group consisting of water, fluorocarbons, aqueous and fluorocarbon solutions of alcohols, alkoxy alkanols, alkylene carbonates and aqueous solutions of heterocyclic compounds or other chelating agents.

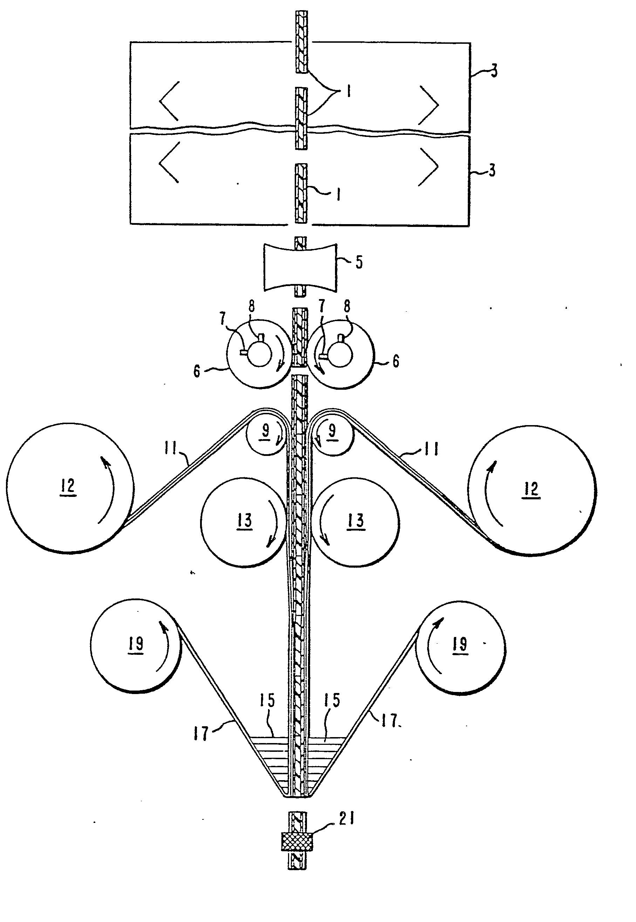

Further advantages and details of the invention will be apparent by reference to the Drawing which consists of a single figure which illustrates schematically a preferred application of the process of the invention in a continuous laminating process.

A primary goal of the invention is. not only to obtain very good adhesion, but also to obtain such adhesion very rapidly, that is, with nip contact during lamination of as little as about one second and preferably even less. This goal is achieved by virtue of the facts (1) that the thin layer first prepares the surface and (2) that it is then almost instantaneously displaced from the surface primarily by absorption into the photolayer. When more volatile liquids are used to form the thin film, and especially when elevated laminating.temperatures are used, the thin film may be displaced to a minor extent by evaporation as well. In any event, the rapid displacement of the thin layer from the substrate surface assures that it cannot interfere with adhesion upon that surface.

In practicing this invention absorbable liquids used for treating the substrate surface are applied as a thin film immediately before lamination. These liquids may be applied in a separate step or as an integral part of the board prelamination cleaning operation, wherein a substrate surface is mechanically or chemically cleaned, optionally rinsed and excess liquid removed to leave sufficient liquid to form a thin layer of liquid on the substrate surface for lamination.

The liquids useful in this invention must be nonsolvents for the thermoplastic polymer being laminated. To be useful the liquid must also be capable of being absorbed by the film or diffusing through the polymer film. Although the nonsolvent liquids useful in this invention may be capable of dissolving some components of the photoresist material, the liquids must be incapable under the conditions of lamination of dissolving the components essential for forming the photoresist, that is, the binder, monomer and initiator.

Proper selection of the absorptive liquid is essential to form an instantaneous and strong bond between the thermoplastic layer and a nonporous substrate since any liquid remaining at the interface will act as a release layer and substantially weaken the bond. Instant adhesion is particularly important in high productivity or on-line processes where the film support is removed from a photosensitive thermoplastic layer within 1—2 minutes (preferably 1 to 30 seconds) after lamination of this layer to a nonporous substrate. Preferably the liquid should quickly diffuse, vaporize or be absorbed into the layer.

Suitable nonsolvent liquids include water, fluorocarbons, aqueous and fluorocarbon solutions of alcohols, alkoxyalkanols, e.g., 2-ethoxy ethanol, and alkylene carbonates, e.g., ethylene carbonate, and aqueous solutions of heterocyclic compounds such as those described in U.S. Patent 3,645,772, or other chelating agents. Particularly preferred are solutions of methanol or ethanol in water.

The suitability of liquids for use in the process of the invention for laminating photosensitive layers is determined by the following test procedure: a 23 cm (nine-inch) by 30 cm (twelve-inch) section of photoresist film is immersed in 1,800 cm³ of the test liquid for thirty seconds at room temperature and is then removed. The test liquid is evaporated down to a residue of 10 cm³ and coated on conventional glass microscope slides. The coated slides are exposed to mercury light of a 1 KW Colight® DMVL-HP Exposure Source for two minutes after which the coatings are checked for hardening and color change, either of which indicates that essential components of the photoresist film were soluble in and therefore extracted by the test liquid.

The thin liquid layer should cover at least 30 percent of the substrate surface on which the polymer is to be laminated preferably as a uniform layer of minute droplets. At least 80 percent coverage is preferred and essentially complete coverage is still further preferred in the form of a continuous film.

In practice, it is preferred that the thin liquid layer be as thin as is practicable. While the particular layer thickness will vary considerably, depending upon the nature of the liquid and the conditions of application, it is generally preferred that it be at least about one μm, the average layer thickness being about 30 μm or from about 10 to about 50 μm.

It is an essential aspect of the invention that the applied thin liquid film be substantially displaced from the interface between the photosensitive layer and the substrate during the subsequent laminating operation. This is done mainly by absorption into the laminated polymeric layer. As used herein, the term "absorption" is not used in the usual unit operations sense, but refers to the direct transfer of the thin liquid layer under lamination pressure from the interface between the substrate and photosensitive layer into the solid photosensitive layer in which it is diffused. The precise method by which the thin liquid film is displaced is, of course, a function of the liquid and the nature of the photosensitive layer and substrate which are used. When a more volatile liquid is used in conjunction with heated laminating rolls, liquid film displacement may take place partially by vaporization. On the other hand, using a less volatile liquid and/or cooler rolls will result in less volatilization and thus removal of the liquid film will occur to a greater extent by absorption into the laminated photosensitive layer. Obviously, when nonvolatile liquids are used, the removal of the liquid film takes place essentially by absorption. The precise mechanism by which the liquid film is removed is not critical so long as the liquid is compatible with the laminated photosensitive layer.

Though the invention may be used advantageously in the lamination of a broad spectrum of thermoplastic layers, the invention is particularly useful for the lamination of photosensitive resist elements to substrates which are to be used for making printed circuit boards. The invention is also useful for lamination of photosensitive layers to substrates in the preparation of lithographic printing plates.

In practicing the invention, photosensitive film resist elements of various types may be used. In general photohardenable, negative-working elements are photopolymerizable elements of the type disclosed in U.S. Patent 3,469,982 and the photocrosslinkable elements of the type disclosed in U.S. Patent 3,526,504. Positive-working, resist elements may be of the photosolubilizable type, e.g., such as the o-quinone diazide elements of U.S. Patent 3,837,860, or of the photodesensitizable type, e.g., such as the bisdiazonium salts of U.S. Patent 3,778,270 or the nitroaromatic compositions of U.K. Patent GB—A—1,547,548.

An element containing an image-yielding, nonblocking photopolymerizable stratum on a strippable support is preferably used such as the one described in copending European Patent Application 81 103 996.5 (EP—A—41640). Alternatively, particularly if the photopolymerizable layer is tacky, the remaining surface of the supported, photopolymerizable stratum may be protected by a removable cover sheet or when the element is stored in roll form, the stratum surface may be protected by the contiguous reverse surface of the support. The photosensitive composition is present in a dry coating thickness of about 0.0008 cm (0.0003 inch) to about 0.025 cm (0.01 inch) or more. A suitable strippable support which preferably has a high degree of dimensional stability to temperature changes, may be chosen from a wide variety of films composed of high polymers, e.g., polyamides, polyolefins, polyesters, vinyl polymers, and cellulose esters, and may have a thickness of from ∾0.0006 cm (0.00025 inch) to 0.02 cm (0.008 inch) or more. If exposure is to be made before removing the strippable support, it must, of course, transmit a substantial fraction of the actinic radiation incident upon it. If the strippable support is removed prior to exposure, no such restrictions apply. A particularly suitable support is a transparent polyethylene terephthalate film having a thickness of about 0.0025 cm (0.001 inch).

When the element contains no removable, protective cover sheet and is to be stored in roll form, additional protection against blocking can optionally be provided if the reverse side of the strippable support preferably has applied thereto a thin release layer of a material, such as wax or silicone, to prevent blocking with the photopolymerizable stratum. Alternatively, adhesion to the coated photopolymerizable layer may be preferentially increased by flame treating or electrical discharge treating the support surface to be coated.

Suitable removable, protective cover sheets when used may be chosen from the same group of high polymer films described above and may have the same wide range of thicknesses. A cover sheet of 0.0025 cm (0.001 inch) thick polyethylene is especially suitable. Supports and cover sheets as described above provide good protection to the photopolymerizable resist layer.

When the invention is used in applications in which very rapid adhesion is needed, for example, the self-trimming process disclosed in copending European Patent Application 81 104 013.8 (EP—A—41642), filed concurrently herewith, it is essential that the adhesion ($A_1$) of the unexposed photosensitive layer to the polymeric support exceed the breaking strength (B) of the unsupported photosensitive layer. Likewise,

the adhesion ($A_2$) of the unexposed photosensitive layer to the substrate must exceed the breaking strength (B) of the unsupported photosensitive layer. In addition, since the polymeric support must be strippable from the laminated photopolymerizable layer, the adhesion ($A_2$) of the photolayer to the substrate must also exceed its adhesion ($A_1$) to the polymeric support. Expressed mathematically, $A_2 > A_1 > B$.

The photohardenable layer is prepared from polymeric components (binders), monomeric components, initiators and inhibitors.

Suitable binders which can be used as the sole binder or in combination with others include the following: polyacrylate and alpha-alkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrene polymers and copolymers, e.g., with maleic anhydride and esters; vinylidene chloride copolymers, e.g., vinylidene chloride/acrylonitrile; vinylidene chloride/methacrylate and vinylidene chloride/vinyl acetate copolymers; polyvinyl chloride and copolymers, e.g., polyvinyl chloride/acetate; saturated and unsaturated polyurethanes; synthetic rubbers, e.g., butadiene/acrylonitrile, acrylonitrile/butadiene/styrene, methacrylate/acrylonitrile/butadiene/styrene copolymers, 2-chlorobutadiene-1,3 polymers, chlorinated rubber, and styrene/butadiene/styrene, styrene/isoprene/styrene block copolymers; high molecular weight polyethylene oxides of polyglycols having average molecular weights from about 4,000 to 1,000,000; epoxides, e.g., epoxides containing acrylate or methacrylate groups; copolyesters, e.g., those prepared from the reaction product of a polymethylene glycol of the formula $HO(CH_2)_nOH$, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; nylons or polyamides, e.g., N-methoxymethyl polyhexamethylene adipamide; cellulose esters, e.g., cellulose acetate, cellulose acetate succinate and cellulose acetate butyrate; cellulose ethers, e.g., methyl cellulose, ethyl cellulose and benzyl cellulose; polycarbonates; polyvinyl acetal, e.g., polyvinyl butyral, polyvinyl formal; polyformaldehydes.

Preferably, the binder should contain sufficient acidic or other groups to render the composition processible in aqueous developer. Useful aqueous-processible binders include those disclosed in U.S. Patent 3,458,311 and in U.K. Patent GB—A—1,507,704. Useful amphoteric polymers include interpolymers derived from N-alkylacrylamides or methacrylamides, acidic film-forming comonomer and an alkyl or hydroxyalkyl acrylate such as those disclosed in U.S. Patent 3,927,199.

Suitable monomers which can be used as the sole monomer or in combination with others include the following: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent 3,380,831, 2,2-di(p-hydroxyphenyl)-propane diacrylate, pentaerythritol tetraacrylate, 2,2-di-(p-hydroxyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl) ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene.

In addition to the ethylenically unsaturated monomers mentioned above, the photohardenable layer can also contain at least one of the following free radical-initiated, chain-propagating, addition-polymerizable, ethylenically unsaturated compounds having a molecular weight of at least 300.

Preferred monomers of this type are an alkylene or a polyalkylene glycol diacrylate prepared from an alkylene glycol of 2 to 15 carbons or a polyalkylene ether glycol of 1 to 10 ether linkages, and those disclosed in U.S. Patent 2,927,022, e.g., those having a plurality of addition polymerizable ethylenic linkages particularly when present as terminal linkages. Especially preferred are those wherein at least one and preferably most of such linkages are conjugated with a double bonded carbon, including carbon double bonded to carbon and to such heteroatoms as nitrogen, oxygen and sulfur. Outstanding are such materials wherein the ethylenically unsaturated groups, especially the vinylidene groups, are conjugated with ester or amide structures.

Preferred free radical-generating addition polymerization initiators activatable by actinic light and thermally inactive at and below 185°C include the substituted or unsubstituted polynuclear quinones which are compounds having two intracyclic carbon atoms in a conjugated carbocyclic ring system, e.g., 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthra-quinone, 2,3-diphenylanthraquinone, sodium salt of anthraquinone alpha-sulfonic acid, 3-chloro-2-methylanthraquinone, retenequinone, 7,8,9,10-tetrahydronaphthacenequinone, and 1,2,3,4-tetra-hydrobenz(a)anthracene-7,12-dione.

Other photoinitiators which are also useful, even though some may be thermally active at temperatures as low as 85°C, are described in U.S. Patent 2,760,863 and include vicinal ketaldonyl alcohols, such as benzoin, pivaloin, acyloin ethers, e.g., benzoin methyl and ethyl ethers; α-hydrocarbon-substituted aromatic acyloins, including α-methylbenzoin, α-allylbenzoin and α-phenylbenzoin. Photoreducible dyes and reducing agents disclosed in U.S. Patents: 2,850,445; 2,875,047; 3,097,096; 3,074,974; 3,097,097; and 3,145,104 as well as dyes of the phenazine, oxazine, and quinone classes; Michler's ketone, benzophenone, 2,4,5-triphenyl-imidazolyl dimers with hydrogen donors, and mixtures thereof as described in U.S. Patents: 3,427,161; 3,479,185; and 3,549,367 can be used as initiators. Also useful with photoinitiators and photoinhibitors are sensitizers disclosed in U.S. Patent 4,162,162.

Thermal polymerization inhibitors that can be used in photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-toluquinone and chloranil. Also useful for thermal polymerization inhibitors are the nitroso compositions disclosed in US—A—4,168,982.

Various dyes and pigments may be added to increase the visibility of the resist image. Any colorant used, however, should preferably be transparent to the actinic radiation used.

Generally, suitable substrates for the process of the invention involving printed circuit formation are those which have mechanical strength, chemical resistance and good dielectric properties. Thus, most board materials for printed circuits are thermosetting or thermoplastic resins usually combined with a reinforcing filler. Thermosetting resins with reinforcing fillers are ordinarily used for rigid boards, whereas thermoplastic resin without reinforcements are usually used for flexible circuit boards. Ceramic and dielectric-coated metals are also useful. The materials from which the board is made may, of course, influence the choice of liquid for the thin layer.

Typical board construction involves combinations such as phenolic or epoxy resins on paper or a paper-glass composite, as well as polyester, epoxy, polyimide, polytetrafluorethylene, or polystyrene on glass. In most instances, the board is clad with a thin layer of electroconductive metal of which copper is by far the most common.

Suitable substrates for the process of the invention involving preparation of lithographic printing plates are those which have mechanical strength and surfaces which differ in hydrophilicity or oleophilicity from the surfaces of the imaged photosensitive areas laminated thereto. Such substrates are disclosed in U.S. Patent 4,072,528. While numerous substrates are satisfactory for this purpose thin anodized aluminum plates such as those disclosed in U.S. Patent 3,458,311 are particularly useful.

As noted above, the adhesion of the unexposed photosensitive layer to substrates such as copper or aluminum ($A_2$) must be greater than its adhesion to the support ($A_1$). A high value for $A_2$ is also needed for many of the applications of this invention where the photoresist layer must remain adhered to the substrate during exposure to severe chemical or mechanical conditions.

It is essential that the printed circuit substrates used in the process of the invention be clean and free of any extraneous material which might render any significant amount of the surface nonwettable. For this reason, it will frequently be desired to clean printed circuit substrates prior to lamination by one or more of the several cleaning processes which are well-known in the field of printed circuit board manufacture. The particular type of cleaning depends upon the type of contamination—organic, particulate or metallic. Such methods include degreasing with solvents and solvent emulsions, mechanical scrubbing, alkaline soaks, acidification and the like, followed by rinsing and drying.

Suitable cleanliness can be very easily determined by dipping the substrate into water, removing it from the water and observing the board surface. If a uniform film of water is observed, the board is adequately clean but if a discontinuous streaked film or large droplets are formed, the board is not sufficiently clean to be used in the process of the invention.

The inert liquid used to form the thin film can be applied in several ways, for example, by brushing, wicking or by rolling it on using perforated or porous rolls.

The invention will be more clearly understood by reference to the following examples and the detailed description of the drawing hereinbelow.

Example I—Resist properties

A roll of photoresist film having no cover sheet is prepared as follows:

A photosensitive coating solution is prepared having the following composition:

| Component | Parts by weight |
|---|---|
| (a) 1:1 Copolymer of styrene and maleic anhydride partially esterified with isobutyl alcohol; mol. wt. ca. 20,000; acid number ca. 180 | 40 |
| (b) Terpolymer of 7% ethyl acrylate, 71% methyl methacrylate, and 12% acrylic acid; mol. wt. ca. 300,000; acid number ca. 105 | 12.6 |
| (c) Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 5 |
| (d) Polyoxyethylated trimethylolpropane triacrylate (20 moles of ethylene oxide) (M.W. 1162) | 10 |
| (e) Trimethylolpropane triacrylate | 12.5 |
| (f) Benzophenone | 4 |
| (g) 4,4'-Bis(dimethylamino) benzophenone (Michler's ketone) | 0.7 |
| (h) 2,2'-Bis(2-chlorophenyl)-4,4',5,5'-tetraphenyl biimidazole | 3 |
| (i) Leuco crystal violet | 0.4 |
| (j) Benzotriazole | 0.2 |
| (k) 1,4,4-Trimethyl-2,3-diazobicyclo-[3.2.2]-non-2-ene-2,3-dioxide | 0.06 |
| (l) Victoria Green (C.I. Pigment Green 18) | 0.03 |
| (m) Methylene chloride | 200 |
| (n) Methanol | 15 |

Into the above coating solution are dispersed 13 parts by weight of polyethylene beads of which 85% have diameters below 10 µm and 15% have diameters between 10 and 20 µm. The mixture is coated on a 0.00127 cm thick poly(ethylene terephthalate) web which has coated on its reverse side a thin layer of a mixture of Carnuba wax and poly(vinylidene chloride). The photopolymerizable layer is dried to give a dry thickness of 0.00254 cm and about 30.5 meters of the dried coated element is wound into a roll.

Turning now to the drawing, each member of a series of substrates for printed circuits 1 is mechanically advanced in a continuous manner on a roller conveyor through cleaning chamber 3 in which both the upper and lower copper-clad surfaces thereof are cleaned by mechanically scrubbing under a heavy water spray. The boards are made of fiberglass-reinforced epoxy resin. The cleaned substrate boards, which are clean as defined by the uniform water film test, are further advanced through alignment rolls 5 by which the sides of the boards are precisely aligned. From the alignment rolls 5, each aligned board emerges and is passed between liquid application rolls 6 into which thin layer liquid (in this case, water) is admitted via line 7 into the interior of the hollow application rolls 6. Preferably the application rolls 6 consists of a metal core perforated in a regular pattern having thereon a hard porous polyethylene sleeve which is covered with a cotton cloth through which the thin layer liquid passes and is coated onto the substrate. Liquid level within the application rolls 6 is limited by fixed level outlet line 8. The board with both surfaces coated with a thin layer of water is then advanced to a set of upper and lower feed rolls 9 each

6

of which places the unprotected surface of the photosensitive layer of the continuous resist film 11 from Example I against the thin layer. The feed rolls 9 are mechanically linked with the mechanism used for advancing the boards 1 in such manner that the boards are butted up against one another as they enter the feed rolls 9 and there is no significant amount of bridging by the film 11 between the trailing and leading edges of each board. The laminating film prepared as described in Example I is supplied from supply roll 12. The abutting boards 1 with the film resist 11 in place is then advanced through the nips of heated laminating rolls 13 in which the film layers 11 are subjected to both pressure and heat, by which the thin water layer on the photosensitive layer is removed from the substrate mainly by absorption into the photosensitive layer. The temperature of the laminating roll surfaces is about 110°C (230°F) and the linear speed of the boards through the laminator is about six feet per minute. Minor amounts of water are removed by evaporation. Lamination is completed within about 40 seconds after the board is cleaned. The laminated boards 1 still abutting each other, are advanced at a uniform rate between wedges 15. At the exit of the wedges 15, the polyethylene terephthalate web 17 on the outer surface of the continuous film is pulled back uniformly from the substrate at an obtuse angle (here 150°) which causes the photosensitive layer to be trimmed in a straight line along the leading edge of the board 1). The web 17 is pulled back by the action of take-up rolls 19 and the advancing action of the board. As the substrate board 1 emerges from between wedges 15 progressively more of the photosensitive layer is uncovered until the board advances to and is grasped firmly at the sides between a pair of clutch-driven, rapidly rotating trimming rolls 21 (only one is shown) which rotate at a speed faster than the linear speed of the advancing board until they grasp the panel sides. The trimming rolls then move with the linear speed of the board by means of a slip clutch which compensates for the difference in driving speeds. The trimming rolls 21 place a transverse tensile stress on the board which causes the thermoplastic layer to be trimmed smoothly along the trailing edge of the board as it emerges from between the wedges 15. When the trailing edge trimming is completed, thus separating the leading and trailing boards in the series, the laminated board is ready for circuit preparation by conventional photoresist techniques.

In a preferred aspect, the process is simultaneously practiced on both sides of the succession of substrates so that photopolymerizable layer is laminated to both sides of the substrates. In this instance, it is especially important that no liquid be present in the holes in the substrate, lest the heat of lamination vaporize the liquid and cause the "tents" of photosensitive layer over the holes in the substrate to expand and burst. It is also preferred that the succession of substrates be close enough that the spring-loaded lamination rolls normally used for lamination do not "bottom" between substrates. This avoids bonding together of the two photopolymerizable layers extending between the successive substrates, that is the "hinges" between successive substrates, since such bonding is likely to interfere with self-trimming of the leading edge when the support films are removed. Alternatively, the pressure on the lamination rolls can be reduced to minimize bonding of the layers. It is preferred, however, that "hinging" itself be kept to a minimum to facilitate the self-trimming function.

Though the process of the invention as described above is carried out continuously, it will be recognized that the process can also be conducted intermittently as well.

Example II—Importance of cleaning

Two boards of the type described in Example I which have been handled and have fingerprints on the copper surfaces are used in the following test: one board is cleaned and dried in the manner described above and is found to be "clean" as measured by the above-described water film test. Water is applied to the surface of both boards by wiping the surfaces with water saturated tissue.

The water on the clean board is a uniform film with no apparent discontinuities while the water on the uncleaned board is streaked on the surface. Both boards are then laminated with the film of Example I as described above using hot nip rolls at a rolled surface temperature of 110°C (230°F). When subjected to a tape delamination test as described below the polymer laminated to the clean board does not delaminate while the polymer laminated to the board which has not been cleaned encourages substantial delamination.

In the above-referred tape delamination test, a six-inch length of one-inch wide Scotch® brand black poly/paper masking tape is firmly applied to the laminated photosensitive surface and then one edge is pulled away from the surface. Lamination is unsatisfactory if any of the photosensitive layer is pulled off with the tape.

Example III—Positive photoresist lamination

A photosensitive coating composition is prepared as follows:

| Component | Parts by weight |
|---|---|
| (a) Methyl methacrylate/methacrylic acid (92/8) copolymer medium molecular weight | 54.4 |
| (b) Trimethylolpropane triacrylate | 36 |
| (c) 2,2'-Bis(2-chlorophenyl)-4,4',5,5'-tetraphenyl biimidazole | 3 |
| (d) Triethyleneglycol diacetate | 1 |
| (e) Tricresyl phosphate | 3 |
| (f) 3-[N-ethyl-2,3,4-trihydro-1H-benzo[b]-pyridin-6-yl]methylidyne-2,3-dihydro-4-H-1-benzopyran-4-one | 1 |
| (g) 4,5-Dimethoxy-2-nitro-1[-1[4(1,1-dimethyl ethyl)phenoxy]ethyl]-benzene | 4 |
| (h) Benzotriazole | 0.2 |
| (i) CI-109 Red Dye | 0.3 |
| (j) Methylene chloride | 150 |
| (k) Methanol | 11 |
| (l) Polyethylene beads of Example 1 | 15 |

The mixture is coated on a 0.00127 cm thick polyethylene terephthalate web and dried to give a photosensitive layer with a dry thickness of 0.00254 cm.

The photosensitive layer is laminated to one side of cleaned copper-clad substrate boards and self trimmed as in Example I except that the thin layer of liquid consists of 30% ethanol in water.

Each of the laminated and trimmed boards is imaged by exposing for sixty seconds the photosensitive layer to UV radiation from a Colight® DMVL-HP light source passing through transparent portions of a phototool corresponding to a printed circuit pattern. The phototool is then removed and replaced with a filter which is opaque to UV radiation below 400 nm and the boards are uniformly exposed for sixty seconds to the visible light of the Colight® DMVL-HP light source. The imagewise exposed areas are completely removed by development in an aqueous solution of 9% ethyleneglycol monobutyl ether and 1% sodium borate. The imaged and developed laminate is ready for circuit preparation by conventional plating and etching photoresist techniques.

Example IV—Preparation of lithographic printing plate

A photosensitive coating mixture is prepared having the following composition:

8

| Component | Parts by weight |
|---|---|
| (a) Terpolymer of 17% ethyl acrylate, 71% methyl methacrylate, and 12% acrylic acid; mol. wt. ca. 300,000; acid number ca. 105 | 5 |
| (b) Interpolymer formed from 40% N-tert.-octyl acrylamide, 34% methyl methacrylate, 16% acrylic acid, 6% hydroxy propyl methacrylate, and 4% t-butyl amino ethyl methacrylate; mol. wt. ca. 50,000 | 51 |
| (c) Polyoxyethylated trimethylolpropane triacrylate (20 moles of ethylene oxide) (M.W. 1162) | 12 |
| (d) Trimethylolpropane triacrylate | 12 |
| (e) Benzophenone | 3 |
| (f) Michler's ketone | 0.25 |
| (g) Polyethylene beads of Example I | 13 |
| (h) 2,2'-Bis(2-chlorophenyl)-4,4',5,5'-tetraphenyl biimidazole | 3 |
| (i) Leuco crystal violet | 0.4 |
| (j) Benzotriazole | 0.2 |
| (k) 1,4,4-Trimethyl-2,3-diazobicyclo-[3.2.2]-non-2-ene-2,3-dioxide | 0.06 |
| (l) Victoria Green (C.I. Pigment Green 18) | 0.03 |
| (m) Methylene chloride | 215 |
| (n) Methanol | 25 |

The mixture is coated on a 0.00127 cm thick polyethylene terephthalate web and dried to give a photopolymerizable layer with a dry thickness of 0.00254 cm.

The photosensitve layer is laminated to the clean anodized surface of a thin aluminum plate and self trimmed using the lamination procedure of Example 1 wherein the thin layer of liquid consists of 30% ethanol in water.

The laminated and trimmed board is imaged by exposing for sixty seconds the photosensitive layer through a halftone transparency to UV radiation from a Colight® DMVL-HP light source. The unexposed areas are completely removed by development in an aqueous solution of sodium carbonate to provide a halftone polymeric image with complementary image areas of bare aluminum surface. The resulting lithographic printing plate is conventionally gummed, inked and used to produce numerous printed copies.

Example V

Example I is repeated using a 1% aqueous solution of benzotriazole hydrochloride as the thin liquid layer and with a 10% methanol solution in trichlorotrifluoroethane. In both instances, lamination and self trimming is satisfactory and the resulting laminated boards can be conventionally imaged and processed to produce printed circuits.

Example VI—Preparation of a lithographic printing plate

A photosensitive coating mixture was prepared and coated as in Example I except that instead of the beads used therein, 16 parts by weight of 1 micron polyethylene beads (Microfine VIII—F. Gold, tradename of Dura Commodities Corporation, Harrison, NY) were dispersed in the coating solution. The surface of a 0.023 cm thick aluminum plate was scrubbed with tungsten carbide brushes in water using a Chemcut®

Model 107 (tradename of Chemcut Corporation, State College, PA) Mechanical Cleaning System and the scrubbed surface was laminated to the photosensitive layer and the layer trimmed as described in Example I.

The laminated and trimmed board was imaged by exposing for 60 seconds the photosensitive layer through a halftone and line transparency to U.V. radiation from a 2000 watt pulsed Xenon arc light source in a flip top platemaker. The unexposed areas were completely removed by development in a 1% aqueous solution of sodium carbonate to provide a halftone polymeric image with complementary image areas of bare aluminum surface. The resulting lithographic printing plate was conventionally gummed with Lydex® Finishing Solution (LDFS) (tradename of E. I. du Pont de Nemours and Company, Wilmington, DE) and mounted on an A. B. Dick Model 380 offset printing press. Using standard inking and fountain solutions, at least 3500 copies of good quality were obtained from the printing plate.

### Claims

1. Process of laminating an absorptive photosensitive layer underlying a flexible support to a substrate surface by means of pressure, comprising the step of applying a thin layer of liquid on the substrate surface immediately prior to lamination, which layer forms an interface between the substrate surface and the photosensitive layer upon lamination and is displaced by absorption into the photosensitive layer during lamination, characterized in that the liquid is a nonsolvent with respect to the photosensitive layer; and is a member selected from the group consisting of water, fluorocarbons, aqueous and fluorocarbon solutions of alcohols, alkoxy alkanols, alkylene carbonates and aqueous solutions of heterocyclic compounds or other chelating agents.

2. The process of claim 1 in which the alkanols are $C_{1-4}$ alkanols.

3. Process of claim 1 characterized in that the alkoxy alkanol is 2-ethoxy ethanol.

4. Process of claim 1 characterized in that the alkylene carbonate is ethylene carbonate.

5. Process of claim 1 characterized in that the nonsolvent liquid includes solutions of methanol or ethanol in water.

6. The process of claim 1 characterized in that the liquid has solids dissolved therein.

7. The process as claimed in anyone of the claims 1 to 6 characterized in that the thin layer is applied by rolling, brushing or wicking the liquid onto the substrate.

8. The process as claimed in anyone of the claims 1 to 7 characterized in that the lamination is conducted by means of heated nip rolls.

### Patentansprüche

1. Verfahren zum Laminieren einer unter einem flexiblen Träger liegenden absorptionsfähigen lichtempfindlichen Schicht auf eine Substrat-Oberfläche mit Hilfe von Druck mit dem Schritte des Aufbringens einer dünnen Flüssigkeitsschicht auf die Substrat-Oberfläche unmittelbar vor dem Laminieren, wobei diese Schicht beim Laminieren eine Grenzschicht zwischen der Substrat-Oberfläche und der lichtempfindlichen Schicht bildet und während des Laminierens durch Absorption in die lichtempfindliche Schicht hinein verdrängt wird, dadurch gekennzeichnet, daß die Flüssigkeit ein Nicht-Lösungsmittel bezüglich der lichtempfindlichen Schicht ist und eine aus der aus Wasser, Fluorokohlenstoff-Verbindungen, wäßrigen und Fluorokohlenstoff-Lösungen von Alkoholen, Alkoxyalkanolen, Alkylencarbonaten und wäßrigen Lösungen heterocyclischer Verbindungen oder anderer chelatbildender Mittel bestehenden Gruppe ausgewählte Substanz ist.

2. Verfahren nach Anspruch 1, dadurch gekennzeichnet, daß die Alkanole $C_{1-4}$-Alkanole sind.

3. Verfahren nach Anspruch 1, dadurch gekennzeichnet, daß das Alkoxyalkanol 2-Ethoxyethanol ist.

4. Verfahren nach Anspruch 1, dadurch gekennzeichnet, daß das Alkylencarbonat Ethylencarbonat ist.

5. Verfahren nach Anspruch 1, dadurch gekennzeichnet, daß das Nicht-Lösungsmittel Lösungen von Methanol oder Ethanol in Wasser einschließt.

6. Verfahren nach Anspruch 1, dadurch gekennzeichnet, daß die Flüssigkeit in ihr gelöste Feststoffe enthält.

7. Verfahren nach irgendeinem der Ansprüche 1 bis 6, dadurch gekennzeichnet, daß die dünne Schicht durch Walzen, Bürsten, Pinseln oder mittels Docht-Auftrag auf das Substrat aufgebracht wird.

8. Verfahren nach irgendeinem der Ansprüche 1 bis 7, dadurch gekennzeichnet, daß die Laminierung mittels beheizter Quetschwalzen durchgeführt wird.

### Revendications

1. Procédé pour stratifier par pression sur une surface de substrat une couche photosensible absorbante sous-jacente à un support souple, comprenant l'étape consistant à appliquer une couche mince de liquide sur la surface du substrat immédiatement avant la stratification, cette couche formant une interface entre la surface du substrat et la couche photosensible lors de la stratification et étant déplacée par absorption dans la couche photosensible pendant la stratification, caractérisé en ce que le liquide est un non-solvant pour la couche photosensible; et est un élément choisi dans le groupe constitué par l'eau, les fluorocarbures, les solutions dans l'eau et les fluorocarbures d'alcools, d'alcoxy-alcanols, de carbonates d'alkylènes et les solutions aqueuses de composés hétérocycliques ou autres agents chélatants.

2. Le procédé selon la revendication 1 dans lequel les alcanols sont les alcanols en $C_1$—$C_4$.

3. Procédé selon la revendication 1, caractérisé en ce que l'alcoxy-alcanol est le 2-éthoxy-éthanol.

4. Procédé selon la revendication 1, caractérisé en ce que le carbonate d'alkylène est le carbonate d'éthylène.

5. Procédé selon la revendication 1, caractérisé en ce que le liquide non-solvant comprend des solutions de méthanol ou d'éthanol dans l'eau.

6. Le procédé selon la revendication 1, caractérisé en ce que le liquide contient des solides à l'état dissous.

7. Le procédé tel que revendiqué dans l'une quelconque des revendications 1 à 6, caractérisé en ce que la couche mince est appliquée en appliquant le liquid eau rouleau, à la brosse ou à la mèche sur le substrat.

8. Le procédé tel que revendiqué dans l'une quelconque des revendications 1 à 7, caractérisé en ce que la stratification est effectuée au moyen de rouleaux pinceurs chauffés.